# EUROPÄISCHE PATENTSCHRIFT

(11) **EP 2 324 141 B1**
(45) Veröffentlichungstag und Bekanntmachung des Hinweises auf die Patenterteilung: **29.04.2015**
(21) Anmeldenummer: 09782226.6
(22) Anmeldetag: 26.08.2009
(51) Int. Cl.: C23C 28/00, C23C 14/00, C23C 16/00, C23C 30/00

(54) **VERSCHLEIß- UND KORROSIONSHEMMENDER SCHICHTVERBUND**
WEAR AND CORROSION RESISTANT LAYERED COMPOSITE
COUCHE COMPOSITE DE PROTECTION CONTRE L'USURE ET LA CORROSION

(30) Priorität: 02.09.2008 DE 102008045381
(43) Veröffentlichungstag der Anmeldung: 25.05.2011
(73) Patentinhaber: Schaeffler Technologies AG & Co. KG, 91074 Herzogenaurach (DE)
(72) Erfinder: HOSENFELDT, Tim , Matthias, 90480 Nürnberg (DE); HAAG, Bertram, 91486 Uhlfeld (DE); MUSAYEV, Yashar, 90419 Nürnberg (DE)
(86) Internationale Anmeldenummer: PCT/EP2009/061010
(87) Internationale Veröffentlichungsnummer: WO 2010/026092

(56) Entgegenhaltungen:
- WO-A-02/27065
- DE-A1-102007 035 342
- GB-A- 2 455 993
- US-A1- 2002 136 840

## Beschreibung

Die vorliegende Erfindung betrifft ein Lagerbauteil mit einem verschleiß- und korrosionshemmenden Schichtverbund und ein Herstellungsverfahren eines solchen Lagerbauteils mit Schichtverbund.

Beschichtungen werden verwendet, um tribologisch- und korrosionsbeanspruchte Bauteile vor Verschleiß zu schützen. Vielfach erfolgt dieser Verschleiß, insbesondere bei Werkstoffpaarungen, die sich nicht im hydrodynamischen Schmierzustand gegeneinander bewegen, aufgrund verschiedener Verschleißmechanismen, welche einzeln oder in Kombination auftreten. Aus diesen Gründen gewinnt die optimale Beanspruchungsgerechte Gestaltung von bewegten Bauteilen mittels Verschleiß- und Korrosionsschutzschichten immer mehr an Bedeutung.

Es existieren einzelne Verfahren, durch welche gezielt tribologische Eigenschaften verbessert werden können, jedoch ohne eine geeignete Korrosionsschutzleistung zu bieten. Die nach dem Stand der Technik verfügbaren Korrosionsschutzschichten weisen keine ausreichenden tribologischen Eigenschaften, wie z. B. Reibungsminimierung und Verschleißbeständigkeit auf. Es sind Schichtsysteme bekannt, die mittels PVD (physikalischer Gasphasenabscheidung) oder PACVD (plasmaunterstützter chemischer Gasphasenabscheidung) aufgebracht werden, die gute tribologische Eigenschaften jedoch nur einen unzureichenden Korrosionswiderstand aufweisen. Für den Korrosionsschutz sind galvanisch oder chemisch oder autokatalytisch aufgebrachte Schutzschichten bekannt, die jedoch nur eine geringe tribologische Widerstandsfähigkeit aufweisen.

Aus der DE 10 2006 049 756 A1 ist eine Verschleißschutzschicht bekannt, die aus mehreren Lagen unterschiedlicher hartstoffhaltiger und metallischer Phasen gebildet ist. Eine besondere Korrosionsschutzschicht ist bei diesem Schichtsystem nicht vorgesehen.

Aus der DE 2417920A ist ein Verfahren zur Herstellung einer Chromcarbidschicht auf der Oberfläche eines Gegenstandes aus Eisen, einer Eisenlegierung oder Hartmetall bekannt. Dabei wird ein Schmelzbad mit einem Chromhalogenid und Borsäure und/oder Borat verwendet.

Aus der DE 10 242 421 A1 ist eine Beschichtung zum Schutz eines Substrates vor Verschleiß und Korrosion auf der Basis von Niobnitrid oder Niobmetallnitrid bekannt, wobei Zwischenschichten zur Verbesserung der Haftung aufgebracht werden. Niobnitrid ist eine Hartstoffschicht mit einer sehr großen Härte. Des Weiteren ist Niobnitrid extrem resistent gegen einen korrosiven Angriff. Die Niobnitridschicht erfüllt somit sowohl die Aufgabe eines Korrosionsschutzes als auch einer tribologisch resistenten Beschichtung. Die Beschichtung mit einer Niobnitridschicht ist jedoch relativ kostenintensiv.

Die DE 10 2005 045 701 A1 beschreibt einen Gleitlagerverbundwerkstoff zur Herstellung von Gleitlagerelementen, insbesondere Gleitlagerbuchsen und Gleitlagerschalen für motorische Anwendungen. Der Gleitlagerverbundwerkstoff umfasst eine Trägerschicht aus Stahl und einer darauf aufgebrachten Lagermetallschicht auf Kupferbasis und mit einer auf die Lagermetallschicht aufgesputterten Laufschicht auf Aluminiumbasis.

Es ist somit Aufgabe der vorliegenden Erfindung, ein Schichtsystem zur Verfügung zu stellen, welches auf Eisenwerkstoffe aufgebracht werden kann und sehr gute tribologische Eigenschaften mit ausgezeichneten Korrosionsschutzeigenschaften kombiniert sowie kostengünstig herstellbar ist. Erfindungsgemäß wird diese Aufgabe vorrichtungsseitig durch ein Schichtsystem mit den Merkmalen des Patentanspruchs 1 und verfahrensseitig durch ein Verfahren zum Aufbringen des Schichtsystems nach Patentanspruch 6 gelöst.

Ein erfindungsgemäßer Schichtverbund besteht aus einem Substrat aus einem Eisenwerkstoff, wobei eine Laufläche des Substrats mittels einer PVD/PACVD-Beschichtung beschichtet ist. Erfindungsgemäß ist die PVD/PACVD-Beschichtung unmittelbar auf dem Eisenwerkstoff aufgebracht. Eine Sol-Gel-Korrosionsschutzschicht ist auf der PVD/PACVD-Beschichtung angeordnet, wobei die PVD-PACVD-Beschichtung Poren aufweist, in die die Sol-Gel-Korrosionsschutzschicht hineinragt und die die Poren verschließt. Seitenflächen des Substrats weisen eine galvanische, chemische oder autokatalytische Schicht auf.

Die der vorliegenden Erfindung zugrunde liegende Idee besteht darin, dass ein hybrides Schichtsystem gebildet wird, das aus einer Hartstoffschicht und einer Sol-Gel-Korrosionsschutzschicht besteht, die auf einen Eisenwerkstoff aufgebracht werden. Dadurch können auf der Bauteiloberfläche gezielt Eigenschaften realisiert werden, die sich aus den Eigenschaften der aufgebrachten Einzelschichten kombinieren.

In den Unteransprüchen finden sich vorteilhafte Ausgestaltungen und Verbesserungen des im Patentanspruch 1 angegebenen Schichtsystems und des im Patentanspruch 6 angegebenen Verfahrens zur Herstellung eines derartigen Schichtsystems.

Die Erfindung wird im Folgenden anhand von Ausführungsbeispielen unter Bezugnahme auf die beiliegenden Figuren näher erläutert. Von den Figuren zeigen:
- Fig. 1: eine schematische Schnittdarstellung eines erfindungsgemäßen Schichtsystems ;
- Fig. 2: eine schematische Schnittdarstellung eines weiteren Schichtsystems;
- Fig. 3: eine schematische Schnittdarstellung eines weiteren;
- Fig. 4: eine schematische Schnittdarstellung eines erfindungsgemäßen Schichtsystems mit einer Deckschicht, einer Funktionsschicht und einem Substrat; und
- Fig. 5: eine schematische Schnittdarstellung eines erfindungsgemäßen Schichtsystems mit einer mehrseitigen Beschichtung eines Substrates.

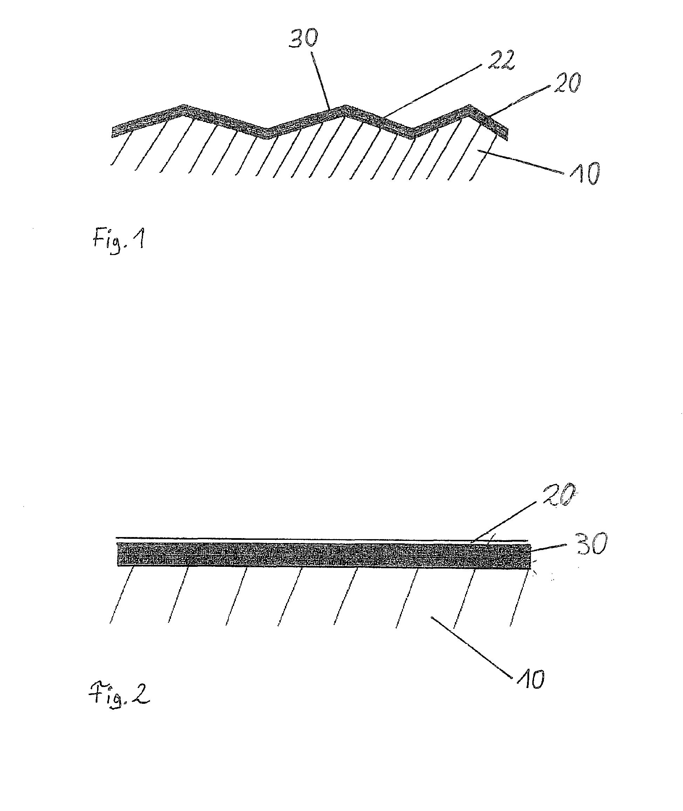

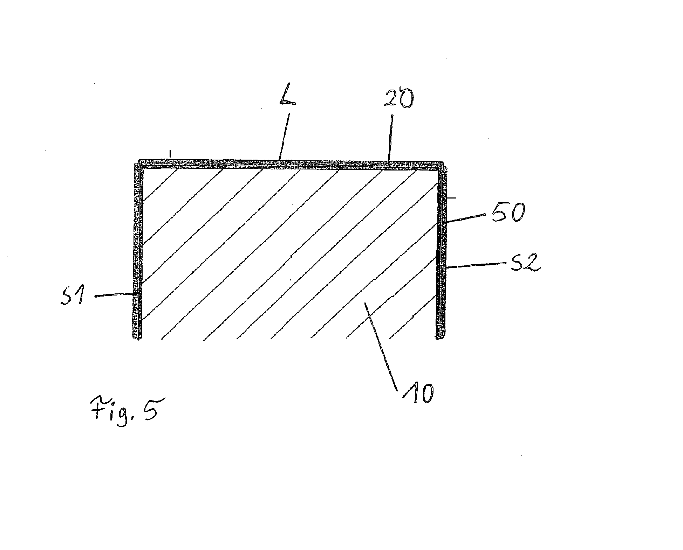

In den Figuren bezeichnen dieselben Bezugszeichen gleiche oder funktionsgleiche Komponenten, soweit nichts Gegenteiliges angegeben ist. Fig. 1 zeigt eine schematische Schnittdarstellung eines erfindungsgemäßen Schichtsystems gemäß einem ersten bevorzugten Ausführungsbeispiel. Eine Lauffläche L (siehe hierzu Figur 5) eines Bauteils bzw. Substrats 10 ist mit einer PVD/PACVD-Beschichtung 20 versehen. Die PVD/PACVD-Beschichtung 20 weist Poren 22 auf. Die PVD/PACVD-Beschichtung ist durch eine Sol-Gel-Korrosionsschutzschicht 30 versiegelt. Das Bauteil besteht aus einem Eisenwerkstoff und ist z. B. ein Lagerbauteil an einer Maschine oder in einem Motor. Die PVD/PACVD-Beschichtung 20 zeichnet sich durch hervorragende tribologische Eigenschaften wie z. B. Reibungsminimierung und Verschleißschutz aus und ist unmittelbar auf den Eisenwerkstoff aufgebracht. Jedoch ist diese Schicht 20 durch ihre geringe Schichtdicke und verfahrensbedingte Eigenschaften nicht komplett geschlossen, das bedeutet die Schicht 20 weist Poren 22, sogenannte PinHoles auf, welche eine korrosionsschützende Barrierewirkung der Schicht 20 verhindern. Um diese tribologisch aktive Schicht 20 zusätzlich mit einer guten Korrosionsschutzleistung zu versehen, ist sie mit einer organisch/anorganisch/mineralischen Versiegelung 30 versehen, welche die PinHoles 22 verschließt und im Überrollzustand in die Poren 22 eingearbeitet wird. Für die Versiegelung 30 werden erfindungsgemäß sogenannte Sol-Gel-Korrosionsschichten 30 eingesetzt. Durch die so erhaltene Isolation ist ein anodischer Korrosionsschutz gewährleistet.

Fig. 2 zeigt eine schematische Schnittdarstellung eines weiteren Schichtsystems, welches nicht unter den Schutzbereich der Ansprüche fällt. Auf einem Bauteil 10 ist eine galvanisch, chemisch oder autokatalytisch aufgebrachte Schicht 20 aufgebracht. Auf der Schicht 30 befindet sich eine PVD/PACVD-Schicht 20.

Die galvanisch, chemisch oder autokatalytisch aufgebrachte Schicht 30 dient als Aufnahmestützschicht für die PVD/PACVD-Schicht 20 und kann sowohl aus Korrosions- als auch aus Verschleißgründen appliziert werden. Aufgrund der Beanspruchung von z. B. Lagerkomponenten kommt es häufig zu tribokorrosiver Belastung und dadurch zu einem Bauteilausfall. Dies bedeutet, dass eine abrasive Beaufschlagung des Bauteils in Kombination mit einer korrosiven Beanspruchung auftritt. Dies wird durch die galvanisch, autokatalytisch oder chemisch aufgebrachte Schicht 30 unterbunden. Zusätzlich ermöglicht diese Schicht 20 wirtschaftliche Vorteile bei der Herstellung, da i. d. R. im PVD/PACVD-Prozess eine haftvermittelnde Schicht zwischen Substrat 10 und tribologischer Funktionsschicht 20 benötigt wird, welche normalerweise in situ, d. h. zum Start des PVD/PACVD-Prozesses durch den PVD-Prozess abgeschieden wird. Durch die vorhergehende galvanische, chemische oder autokatalytische Beschichtung kann dieser Prozessschritt entfallen und dementsprechend die Prozesszeit verkürzt werden. Zudem entfallen die Kosten für die entsprechenden Targetmaterialien für die Stützschicht aus dem PVD-Prozess.

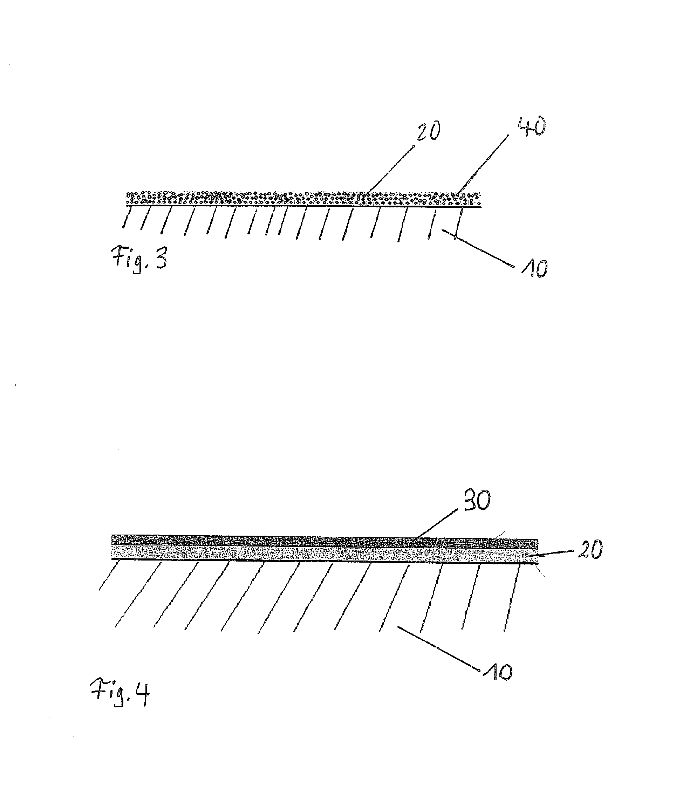

Fig. 3 zeigt eine schematische Schnittdarstellung eines weiteren Schichtsystems, das ebenfalls nicht zum Schutzumfang der Ansprüche gehört.. Auf einem Bauteil 10 befindet sich hierbei eine Chromcarbidschicht 40. Diese Chromcarbidschicht 40 wird erzeugt indem auf das Bauteil 10 eine Schicht 20 aus Chrom bzw. einer Chromlegierung aufgebracht wird. In einem nachfolgenden Verfahrensschritt wird in einem PVD/PACVD-Verfahren die Schicht 20 in eine Chromcarbidschicht 40 z. B. durch einen Ätzverfahrensschritt oder in einem in-situ PVD-Prozess umgewandelt. Dabei wird die Schicht umstrukturiert und verdichtet.

Fig. 4 zeigt eine schematische Schnittdarstellung eines erfindungsgemäßen Schichtsystems mit einer Deckschicht, einer Funktionsschicht und einem Substrat. Auf einem Bauteil 10 befindet sich eine durch einen PVD/PACVD-Prozess erzeugte Schicht 20. Auf dieser Schicht befindet sich eine Deckschicht, die die erfindungsgemäße Sol-Gel-Korrosionsschicht 30 ist. Die Schicht 20 weist eine Porosität in Form von Poren und PinHoles auf und gewährleistet daher keinen ausreichenden Korrosionsschutz. Um einen ausreichenden Korrosionsschutz zu gewährleisten wird das Bauteil nach der Herstellung der Schicht 20 mittels eines PVD/PACVD-Prozesses nachfolgend einer galvanischen, chemischen oder autokatalytischen Behandlung unterzogen, welche die Deckschicht 30 ausbildet, die sowohl einen kovalenten als auch einen ionischen bzw. metallischen Bindungscharakter aufweist. Hierdurch werden die im PVD/PACVD-Prozess entstandenen Poren geschlossen und somit eine anodisch/katodisch korrosionsschützende Wirkung unter Beibehaltung der tribologischen Eigenschaften der PVD/PACVD-Schicht erzeugt.

Fig. 5 zeigt eine schematische Schnittdarstellung eines erfindungsgemäßen Schichtsystems mit einer mehrseitigen Beschichtung eines Substrates. Ein zylinderförmiges Bauteil (z.B. ein Tassenstößel) 10 weist an seiner äußeren Laufflächenseite L eine durch ein PVD/PACVD-Verfahren erzeugte Schicht 20 auf. An der linken Stirnseite S1 und der rechten Stirnseite S2 des Bauteils 10 ist eine galvanisch, chemisch oder autokatalytisch erzeugte Schicht z. B. eine Zinklegierungsschicht aufgebracht. Diese Zinklegierungsschicht 50 bietet einen Korrosionsschutz. Dadurch können gezielt an einem Bauteil die erwünschten Eigenschaften eingestellt und kombiniert werden. In diesem Beispiel weist also das Bauteil eine funktionale tribologisch beanspruchbare Schicht 20 an der Oberseite als auch eine korrosionsschützende Schicht 50 an den Seiten des Bauteils 10 auf. Durch diese Technologie ist es möglich, gezielt Verschleißschutz, Reibungsminimierung und Korrosionsschutz lokal am Bauteil zu realisieren.

### Bezugszeichenliste

- 10: Substrat
- 20: PVD/PACVD-Beschichtung
- 22: Poren
- 30: Korrosionsschutzschicht
- 40: Chromcarbidschicht
- 50: Zinklegierungsschicht
- L: Laufflächenseite
- S1: erste Stirnseite
- S2: zweite Stirnseite

## Patentansprüche

1. Lagerbauteil (10) aus einem Eisenwerkstoff umfassend
eine Lauffläche (L), die mittels einer PVD/PACVD-Beschichtung (20) beschichtet ist,
**dadurch gekennzeichnet dass**
die PVD/PACVD-Beschichtung (20) unmittelbar auf dem Eisenwerkstoff aufgebracht ist,
eine Sol-Gel-Korrosionsschutzschicht (30) auf der PVD/PACVD-Beschichtung (20) angeordnet ist, wobei die PVD-PACVD-Beschichtung (20) Poren (22) aufweist, in die die Sol-Gel-Korrosionsschutzschicht (30) hineinragt und die die Poren (22) verschließt, und
Seitenflächen (S1, S2) des Lagerbauteils (10) eine galvanische, chemische oder autokatalytische Schicht (50) aufweisen.

2. Lagerbauteil nach Anspruch 1,
**dadurch gekennzeichnet,**
**dass** die Sol-Gel-Korrosionsschutzschicht (30) durch die Poren (22) Brücken mit dem Substrat (10) bildet.

3. Lagerbauteil nach Anspruch 1 oder 2,
**dadurch gekennzeichnet,**
**dass** die Sol-Gel-Korrosionsschutzschicht (30) sowohl einen kovalenten als auch einen ionischen bzw. metallischen Bindungscharakter aufweist.

4. Lagerbauteil (10) nach einem der Ansprüche 1 - 3,
**dadurch gekennzeichnet,**
**dass** die Schicht (50) eine galvanische, chemische oder autokatalytisch erzeugte Schicht ist, die sowohl anodischen als auch kathodischen Korrosionsschutz gegenüber Stahl bietet.

5. Lagerbauteil (10) nach Anspruch 4,
**dadurch gekennzeichnet,**
**dass** die Schicht (50) eine Zinklegierungsschicht oder eine Nickellegierungsschicht ist.

6. Verfahren zum Herstellen eines Lagerbauteils nach Anspruch 1 mit folgenden Verfahrensschritten:
a) Bereitstellen eines Lagerbauteils (10) aus einem Eisenwerkstoff;
b) Aufbringen einer PVD/PACVD-Beschichtung (20) unmittelbar auf den Eisenwerkstoff des Lagerbauteils (10) derart, dass die PVD/PACVD-Beschichtung (20) Poren (22) aufweist;
c) Aufbringen einer Sol-Gel-Korrosionsschutzschicht (30) auf die PVD/PACVD-Beschichtung (20) des Lagerbauteils (10), so dass die Sol-Gel-Korrosionsschutzschicht (30) in die Poren (22) der PVD/PACVD-Beschichtung (20) hineinragt; und
d) Aufbringen einer galvanischen, chemischen oder autokatalytischen Beschichtung (50) auf die PVD/PACVD-Beschichtung (20) auf die Seitenflächen (S1, S2) des Lagerbauteils (10).

## Claims

1. Bearing component (10) composed of an iron material comprising
a running surface (L) which is coated with a PVD/PACVD coating (20),
**characterized in that**
the PVD/PACVD coating (20) has been applied directly to the iron material,
a sol-gel corrosion protection layer (30) is arranged on the PVD/PACVD coating (20), wherein the PVD-PACVD coating (20) has pores (22) into which the sol-gel corrosion protection layer (30) projects and closes the pores (22), and
side faces (S1, S2) of the bearing component (10) have an electrochemical, chemical or autocatalytic layer (50).

2. Bearing component according to Claim 1,
**characterized in that**
the sol-gel corrosion protection layer (30) forms bridges to the substrate (10) via the pores (22).

3. Bearing component according to Claim 1 or 2,
**characterized in that**
the sol-gel corrosion protection layer (30) has both covalent bonding character and ionic or metallic bonding character.

4. Bearing component (10) according to any of Claims 1 - 3,
**characterized in that**
the layer (50) is an electrochemically, chemically or autocatalytically produced layer which offers both anodic and cathodic corrosion protection to steel.

5. Bearing component (10) according to Claim 4,
**characterized in that**
the layer (50) is a zinc alloy layer or a nickel alloy layer.

6. Process for producing a bearing component according to Claim 1, which comprises the following process steps:
a) provision of a bearing component (10) composed of an iron material;
b) application of a PVD/PACVD coating (20) directly to the iron material of the bearing component (10) in such a way that the PVD/PACVD coating (20) has pores (22);
c) application of a sol-gel corrosion protection layer (30) to the PVD/PACVD coating (20) of the bearing component (10) so that the sol-gel corrosion protection layer (30) projects into the pores (22) of the PVD/PACVD coating (20); and
d) application of an electrochemical, chemical or autocatalytic coating (50) to the PVD/PACVD coating (20) on the side faces (S1, S2) of the bearing component (10).

## Revendications

1. Composant de palier (10) en matériau ferreux, comportant
une surface de roulement (L) revêtue d'un revêtement (20) en PVD/PACVD,
**caractérisé en ce que**
le revêtement (20) en PVD/PACVD est appliqué directement sur le matériau ferreux,
**en ce qu'**une couche (30) de sol-gel de protection contre la corrosion est disposée sur le revêtement (20) en PVD/PACVD, le revêtement (20) en PVD/PACVD présentant des pores (22) dans lesquels la couche (30) de sol-gel de protection contre la corrosion pénètre et ferme les pores (22), et
**en ce que** des surfaces latérales (S1, S2) du composant de palier (10) présentent une couche (50) galvanique, chimique ou auto-catalytique.

2. Composant de palier selon la revendication 1, **caractérisé en ce que** la couche (30) de sol-gel de protection contre la corrosion forme à travers les pores (22) des ponts avec le substrat (10).

3. Composant de palier selon les revendications 1 ou 2, **caractérisé en ce que** la couche (30) de sol-gel de protection contre la corrosion présente à la fois un caractère de liaison covalente et un caractère de liaison ionique ou métallique.

4. Composant de palier (10) selon l'une des revendications 1 à 3, **caractérisé en ce que** la couche (50) est une couche galvanique, chimique ou auto-catalytique qui offre à l'acier une protection contre la corrosion anodique et contre la corrosion cathodique.

5. Composant de palier (10) selon la revendication 4, **caractérisé en ce que** la couche (50) est une couche d'alliage de zinc ou une couche d'alliage de nickel.

6. Procédé de fabrication d'un composant de palier selon la revendication 1, le procédé présentant les étapes suivantes :
a) préparer un composant de palier (10) en un matériau ferreux,
b) appliquer un revêtement (20) en PVD/PACVD directement sur le matériau ferreux du composant de palier (10) de telle sorte que le revêtement (20) en PVD/PACVD présente des pores (22),
c) appliquer une couche (30) de sol-gel de protection contre la corrosion sur le revêtement (20) de PVD/PACVD du composant de palier (10) de telle sorte que la couche (30) de sol-gel de protection contre la corrosion pénètre dans les pores (22) du revêtement (20) en PVD/PACVD et
d) appliquer un revêtement (50) galvanique, chimique ou auto-catalytique sur le revêtement (20) en PVD/PACVD, sur les surfaces latérales (S1, S2) du composant de palier (10).
